# EUROPEAN PATENT APPLICATION

(11) **EP 2 757 605 A2**
(43) Date of publication of application: **23.07.2014**
(21) Application number: 14151262.4
(22) Date of filing: 15.01.2014
(51) Int. Cl.: H01L 35/30

(54) **Thermoelectric power generation unit**

(30) Priority: 17.01.2013 JP 2013006334
(71) Applicant: YAMAHA CORPORATION, Hamamatsu-shi Shizuoka-ken 430-8650 (JP)
(72) Inventor: Kamimura, Naoki, Shizuoka-ken, 430-8650 (JP); Yoshida, Kosuke, Shizuoka-ken, 430-8650 (JP)
(74) Representative: HOFFMANN EITLE

(57) **Abstract**

A thermoelectric power generation unit includes: a bottom plate and a heat exchange member which are made of a thermal conductor; a thermoelectric power generation module and a spacer which are interposed between the bottom plate and the heat exchange member; and a side wall provided to cover a gap between the bottom plate and the heat exchange member. Moreover, a circuit board on which a circuit that is driven by electric power obtained by the thermoelectric power generation module is mounted is stored in a space surrounded by the bottom plate, the heat exchange member, and the side wall.

## Description

### BACKGROUND OF THE INVENTION

### Field of the Invention

The present invention relates to a thermoelectric power generation unit including a thermoelectric power generation module which generates power using the Seebeck effect.

Priority is claimed on Japanese Patent Application No. 2013-6334, filed on January 17, 2013, the content of which is incorporated herein by reference.

### Description of Related Art

A thermoelectric power generation module converts thermal energy into electric energy using thermoelectric power generation elements through the Seebeck effect. In recent years, a technique of effectively using waste heat using this type of thermoelectric power generation module has attracted attention. For example, this type of thermoelectric power generation module is mounted to the wall surface of a pipe through which a high-temperature fluid flows in a factory, plant, or the like to convert heat from the pipe into electric power for use.

As the prior art documents associated with the thermoelectric power generation module, there are the following patent documents:
Japanese Unexamined Patent Application, First Publication No. 2007-110082;
Japanese Unexamined Patent Application, First Publication No. H11-312828;
Japanese Unexamined Patent Application, First Publication No. 2006-234250;
Japanese Utility Model (Registered) Publication No. 3171039; and
Japanese Unexamined Patent Application, First Publication No. 2001-144337.

Regarding how to use the electric power obtained by the thermoelectric power generation module, various modes may be considered. For example, a temperature monitoring system which uses electric power to drive a sensor for monitoring the temperature of an object (in the above example, the pipe or the like) as a heat source heats the high-temperature side (heat absorption surface) of the thermoelectric power generation module and a transmission circuit that transmits an output signal from the sensor to a predetermined destination and thus does not need an external power supply is constructed. However, it is generally difficult for a user to easily construct the system that does not need an external power supply. The reason is as follows.

First, in a case where power is generated by using the thermoelectric power generation module, when heat dissipation from a heat dissipation surface on the opposite side to the heat absorption surface is insufficient, the power generation efficiency is degraded. Therefore, there is a need to appropriately mount a heat exchange member (for example, a heat sink) having an appropriate size on the heat dissipation surface of the thermoelectric power generation module. However, it is difficult for a general user to select a heat exchange member having an appropriate size or appropriately mount the heat exchange member on the thermoelectric power generation module.

Second, electric power obtained by the thermoelectric power generation module is generally weak, and thus there is a need to increase a voltage using a boost circuit or the like to be supplied to the transmission circuit. That is, in order to construct the system that does not need an external power supply, knowledge about electronic circuits is needed, and even though only this aspect is considered, it is difficult for the user.

Moreover, third, the thermoelectric power generation module is generally vulnerable to impacts, and the thermoelectric power generation module needs to be stored in a housing so as to be protected from impacts and the like, whereas, thermal conduction from the heat source to the thermoelectric power generation module or thermal conduction from the thermoelectric power generation module to the heat exchange member needs to be preserved as much as possible. It is difficult for the general user to achieve both the needs.

### SUMMARY OF THE INVENTION

The present invention has been made taking the foregoing problems into consideration, and an object thereof is to provide a technique of easily constructing a system that does not need an external power supply using a thermoelectric power generation module.

In order to accomplish the object, the present invention provides a thermoelectric power generation unit including: a heat exchange member; a bottom plate made of a thermal conductor; a thermoelectric power generation module interposed between the bottom plate and the heat exchange member; a side wall provided to cover a gap between the bottom plate and the heat exchange member; and a circuit board on which a circuit that is driven by electric power obtained by the thermoelectric power generation module is mounted, the circuit board being stored in a space partitioned by the heat exchange member, the bottom plate, and the side wall.

The thermal conductor is a material having a property of easily transferring heat, and examples thereof include metal such as copper or aluminum. In the thermoelectric power generation unit of the present invention, the thermoelectric power generation module is interposed between the bottom plate and the heat exchange member which are formed of the thermal conductor. Therefore, when the heat exchange member having an appropriate size is selected to configure the thermoelectric power generation unit, the user of the thermoelectric power generation unit does not need to pay attention to the selection or appropriate mounting of the heat exchange member having an appropriate size for the thermoelectric power generation module and does not need to pay attention to the inhibition of thermal conduction from the thermoelectric power generation module to the heat exchange member. Furthermore, since the bottom plate is formed of the thermal conductor, thermal conduction from a heat source to the thermoelectric power generation module is guaranteed only by installing the thermoelectric power generation unit so as to cause the bottom plate to come into close contact with the heat source.

In addition, in the thermoelectric power generation unit of the present invention, since the thermoelectric power generation module is stored in a housing including the bottom plate, the side wall, and the heat exchange member, the user does not need to additionally pay attention to the protection from impacts and the like.

Moreover, in the thermoelectric power generation unit of the present invention, since the circuit board on which the circuit that is driven by the electric power obtained by the thermoelectric power generation module is mounted is stored in the housing (that is, the circuit board is embedded in the thermoelectric power generation unit), knowledge about electronic circuits is not needed during the use of the thermoelectric power generation unit.

### BRIEF DESCRIPTION OF THE DRAWINGS

FIGS. 1A, 1B, and 1C are, respectively, a perspective view, a side cross-sectional view, and a top cross-sectional view illustrating a thermoelectric power generation unit of a first embodiment of the present invention.
FIGS. 2A, 2B, and 2C are side cross-sectional views illustrating modified examples of the first embodiment.
FIGS. 3A, 3B, and 3C are side cross-sectional views illustrating other modified examples of the first embodiment.
FIG. 4 is a side cross-sectional view illustrating a thermoelectric power generation unit of a second embodiment of the present invention.
FIGS. 5A, 5B, and 5C are side cross-sectional views illustrating modified examples of the second embodiment.
FIG. 6 is a side cross-sectional view illustrating a thermoelectric power generation unit of a third embodiment of the present invention.
FIGS. 7A and 7B are side cross-sectional views illustrating modified examples of the third embodiment.

### DETAILED DESCRIPTION OF THE INVENTION

Hereinafter, embodiments of the present invention will be described with reference to the drawings.

### (First Embodiment)

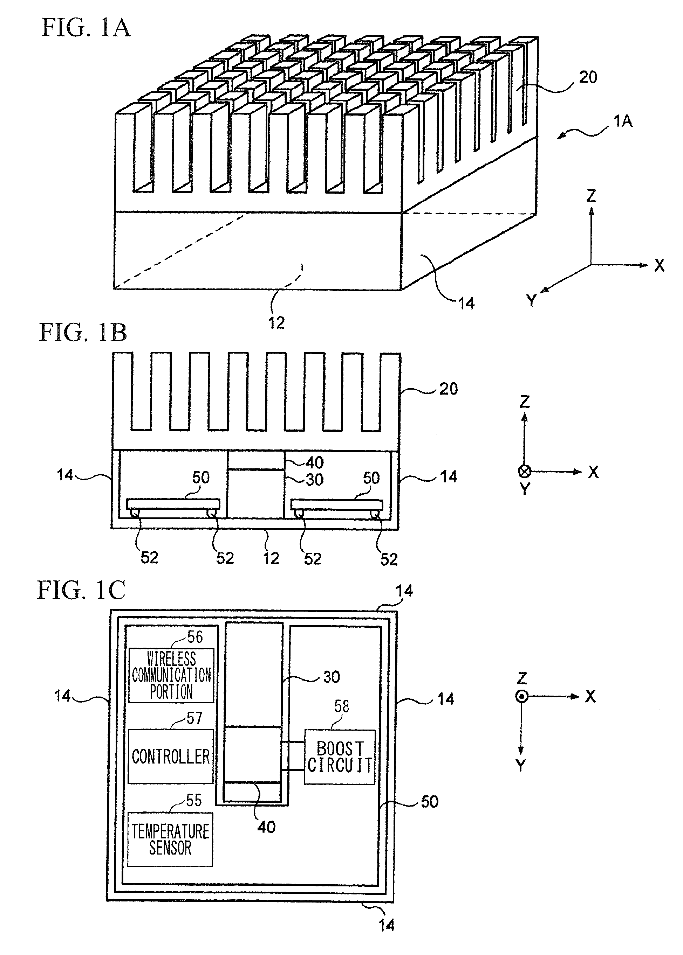

FIG. 1A is a perspective view illustrating the external form of a thermoelectric power generation unit 1A of a first embodiment of the present invention, and FIG. 1B is a side cross-sectional view illustrating the cross-section of the thermoelectric power generation unit 1A along the Z-X plane shown in FIG. 1A.

As illustrated in FIGS. 1A and 1B, the thermoelectric power generation unit 1A of this embodiment includes a case including a bottom plate 12 having a thin plate shape and a side wall 14. In the case, a spacer 30, a thermoelectric power generation module 40, and a circuit board 50 are provided. The opening of the case is covered by a heat exchange member 20 to configure the thermoelectric power generation unit 1A. That is, the bottom plate 12, the side wall 14, and the heat exchange member 20 act as the housing of the thermoelectric power generation unit 1A. A heat absorption surface (the lower surface in FIG. 1B) of the thermoelectric power generation module 40 is thermally connected to the spacer 30, and a heat dissipation surface (the upper surface in FIG. 1B) of the thermoelectric power generation module 40 is thermally connected to the heat exchange member 20.

The case including the bottom plate 12 and the side wall 14 is molded of a thermal conductor so that the bottom plate 12 and the side wall 14 are integrated. In this embodiment, the bottom plate 12 is molded to have a rectangular plate shape of 80 mm×80 mm, and the side wall 14 is molded to have a height (for example, 20 mm to 30 mm) which is the sum of the thickness of the spacer 30 and the thickness of the thermoelectric power generation module 40.

The heat exchange member 20 is a heat sink having a number of fms (in this embodiment, 64 prismatic fins), and is formed of a thermal conductor as in the bottom plate 12 and the like. In this embodiment, the bottom surface (a surface on the side where the fins are not provided) of the heat exchange member 20 is formed to have a rectangular shape having the same dimensions as the bottom plate 12.

The bottom surface of the heat exchange member 20 and the side wall 14 are joined together by welding or adhesion so that dust, moisture, or the like does not infiltrate into the housing of the thermoelectric power generation unit 1A.

In this embodiment, the size of the housing of the thermoelectric power generation unit 1A is set as described above because it is considered that the above-described size is appropriate from the viewpoint of satisfying the following three requests at the same time:
(1) securing a volume which enables the circuit board 50 to be mounted;
(2) securing a sufficient cooling capacity for the thermoelectric power generation module 40 (in other words, securing a sufficient power generation capacity to drive each of circuits mounted on the circuit board 50); and
(3) reducing the size of the thermoelectric power generation unit 1A.

In addition, there may be a case where the outside air side has a higher temperature than an object on which the thermoelectric power generation unit 1A is mounted. In this case, the heat exchange member 20 may be used as a fm for heat absorption.

FIG. 1C is a cross-sectional view of the thermoelectric power generation unit 1A viewed in the Z axis direction in a state where the heat exchange member 20 is removed. As illustrated in FIG. 1C, the spacer 30 is a block-shaped member provided to reach one of four side surfaces from the center of the bottom plate 12 and is formed of a thermal conductor as in the housing of the thermoelectric power generation unit 1A. On the spacer 30, the thermoelectric power generation module 40 having a thin plate shape is installed to be positioned at the center of the housing of the thermoelectric power generation unit 1A. In this embodiment, the thermoelectric power generation module 40 having a thickness of several millimeters and dimensions of 14 mm×14 mm is used.

As illustrated in FIG. 1B, the spacer 30 and the thermoelectric power generation module 40 are installed to be interposed between the bottom plate 12 and the heat exchange member 20. The reason why the thermoelectric power generation module 40 is installed at the center of the housing of the thermoelectric power generation unit 1A is that heat transferred from a heat source to the bottom plate 12 is uniformly transferred to the thermoelectric power generation module 40 via the spacer 30 and heat dissipated from the thermoelectric power generation module 40 is uniformly transferred to the heat exchange member 20.

In addition, in this embodiment, only the single thermoelectric power generation module 40 is provided on the spacer 30. However, a plurality of thermoelectric power generation modules may be arranged on the spacer 30 depending on necessary electric power.

The reason why the spacer 30 is provided in this embodiment is as follows. In general, the thermoelectric power generation module 40 becomes more expensive as the thickness thereof is increased. Therefore, when a sufficient height for mounting circuits between the bottom plate 12 and the heat exchange member 20 is to be secured only by the thickness of the thermoelectric power generation module 40, the thermoelectric power generation unit 1A becomes very expensive.

The spacer 30 is provided to secure the sufficient height for mounting circuits while suppressing an increase in the cost of the thermoelectric power generation unit 1A without impeding thermal conduction from the bottom plate 12 to the thermoelectric power generation module 40. In addition, as long as the sufficient height for mounting circuits can be secured only by the thickness of the thermoelectric power generation module 40 and the cost of the thermoelectric power generation unit 1A can be suppressed to be low, the spacer 30 may not be provided and the thermoelectric power generation module 40 may be provided to be interposed between the bottom plate 12 and the heat exchange member 20.

As illustrated in FIG. 1C, the circuit board 50 is formed to be in a rectangular shape having substantially the same external dimensions (more accurately, slightly smaller dimensions than the bottom plate 12) as the bottom plate 12, and a cutout having a U shape is provided in the circuit board 50 to avoid the spacer 30 (the thermoelectric power generation module 40 in a configuration where the spacer 30 is omitted).

The reason why the circuit board 50 has the above-described dimensions and is provided with the U-shaped cutout is that a larger number of circuits can be mounted as the size of the circuit board 50 is increased and thus it is preferable that the circuit board 50 be made as large as possible in a range in which the circuit board 50 is stored in the housing of the thermoelectric power generation unit 1A and does not impede the thermoelectric power generation module 40 from being installed at the center. In addition, in a case where sufficient electric power is obtained by the single thermoelectric power generation module 40, the spacer 30 having a cubic shape may be used and the circuit board 50 having a rectangular cutout at the center may be used to avoid the spacer 30. In this case, heat can be transferred from the bottom plate 12 to the heat exchange member 20 with good balance, and the space where the circuit board 50 is disposed can be enlarged. In addition, in a case where there is no need to mount a large number of circuits in the circuit board 50, the dimensions of the circuit board 50 may be reduced, and the circuit board 50 does not need to be provided with a cutout as long as the circuit board 50 has a size and a shape that do not interfere with the spacer 30 placed at the center of the housing. The summary is that the circuit board 50 may have any size and shape as long as the circuit board 50 is stored in the housing of the thermoelectric power generation unit 1A and the size and shape thereof do not impede the installation (or the installation of the spacer 30 on which the thermoelectric power generation module 40 is placed) of the thermoelectric power generation module 40 at the center of the housing.

As described above, it is preferable that the thermoelectric power generation module 40 be disposed at the center of the bottom plate 12, the circuit board 50 have the substantially same external dimensions as the bottom plate 12, and the cutout be provided in the circuit board 50 to avoid the thermoelectric power generation module 40. This is because it is considered that heat transferred from the heat source to the bottom plate is uniformly transferred to the thermoelectric power generation module when the thermoelectric power generation module 40 is disposed at the center of the bottom plate 12.

In addition, since a larger number of circuits can be mounted as the size of the circuit board 50 is increased, the size of the circuit board 50 is preferably as large as possible in a range in which the circuit board 50 is stored in the housing and does not impede the installation of the thermoelectric power generation module 40.

In addition, it is preferable that the spacer 30 made of the thermal conductor be provided in the bottom plate 12, and the thermoelectric power generation module 40 be installed to be interposed between the spacer 30 and the heat exchange member 20. In general, since the thermoelectric power generation module 40 becomes more expensive as the thickness thereof is increased, when the sufficient height for mounting circuits between the bottom plate 12 and the heat exchange member 20 is to be secured only by the thermoelectric power generation module 40, the thermoelectric power generation unit 1A becomes very expensive. For this, according to this embodiment, it is possible to secure the sufficient height for mounting circuits without impeding thermal conduction between the bottom plate 12 (or the heat exchange member 20) and the thermoelectric power generation module 40, and to further suppress the cost of the thermoelectric power generation unit to be low.

In addition, in a case of using the spacer 30 as such, the cutout may be provided in the circuit board 50 to avoid the spacer.

In addition, in order to reliably achieve heat exchange between the heat source and the bottom plate 12, a protrusion which is made of a thermal conductor and protrudes from a space partitioned by the heat exchange member into the bottom plate 12 and the side wall 14 may be provided in the bottom plate 12.

As illustrated in FIG. 1C, in the circuit board 50, a temperature sensor 55, a wireless communication portion 56 for wirelessly transmitting an output signal of the temperature sensor 55, a controller 57 which controls the operation of the wireless communication portion 56, and a boost circuit 58 which boosts an output voltage of the thermoelectric power generation module 40 to be applied to the wireless communication portion 56 and the controller 57 are provided.

As illustrated in FIG. 1B, on the rear surface of the circuit board 50, a plurality of legs 52 formed of an insulator such as rubber are provided. The legs 52 separate the rear surface of the circuit board 50 from the bottom plate 12, and are provided to insulate the circuit board 50 from the bottom plate 12. In addition, the positions and the number of legs 52 provided may be appropriately determined in a range in which an object of stably and reliably insulating the circuit board 50 from the bottom plate 12 is achieved. In addition, the legs 52 also have a function of causing the bottom plate 12 and the circuit board not to directly exchange heat. In a case where the bottom plate 12 has a high temperature that can affect the circuit board 50, the circuit board 50 may be fixed to the bottom surface of the heat exchange member 20.

Hereinabove, the configuration of the thermoelectric power generation unit 1A of this embodiment has been described.

In this configuration, a user of the thermoelectric power generation unit 1A of this embodiment can construct a system which monitors the temperature of an object without the need for an external power supply by installing the thermoelectric power generation unit 1A so that the bottom plate 12 comes into close contact with an appropriate place (for example, the side surface of a pipe through which a high-temperature fluid flows in a factory, the side surface of a rail of a bridge or a railroad, the rear side of a manhole cover, or the back surface of home electrical appliances such as a refrigerator or a computer device) of the object which is the heat source for the high-temperature side (heat absorption surface) of the thermoelectric power generation module 40 and requires temperature monitoring. In a case of measuring the temperature of the object in this manner, the temperature sensor may be disposed on the circuit board 50 so that the detection portion of the temperature sensor and the bottom plate 12 come into contact with each other.

As described above, according to this embodiment, the user can easily install the thermoelectric power generation module 40 and the circuits which are driven by the electric power obtained by the thermoelectric power generation module 40 by only installing the thermoelectric power generation unit in a desired place.

For example, the temperature sensor 55, the wireless communication portion 56, the controller 57 which regularly performs a process of transmitting the output signal of the temperature sensor through the wireless communication portion, and the boost circuit 58 which increases the output voltage of the thermoelectric power generation module 40 to be applied to each of the circuits are mounted on the circuit board 50. By mounting the thermoelectric power generation unit so that the bottom plate come into close contact with the object which is the heat source for the thermoelectric power generation unit and requires temperature monitoring, the system which monitors the temperature of the object without the need for the external power supply can be constructed. As described above, according to this embodiment, it is possible to simply configure the system which does not need the external power supply using the thermoelectric power generation module.

In addition, in the thermoelectric power generation unit 1A of this embodiment, the thermoelectric power generation module 40 is interposed between the bottom plate 12 and the heat exchange member 20 which are formed of the thermal conductor along with the spacer 30 formed of the thermal conductor. Furthermore, in this embodiment, the heat exchange member 20 having an appropriate size is mounted on the thermoelectric power generation module 40 in advance. Therefore, the user of the thermoelectric power generation unit 1A needs not to pay attention to the selection or appropriate mounting of the heat exchange member 20 having the appropriate size for the thermoelectric power generation module 40, and does not need to pay attention to the inhibition of thermal conduction from the thermoelectric power generation module 40 to the heat exchange member 20.

Furthermore, in this embodiment, since the bottom plate 12 of the thermoelectric power generation unit 1A is formed of the thermal conductor, thermal conduction from the heat source to the thermoelectric power generation module 40 is guaranteed only by installing the thermoelectric power generation unit 1A so as to cause the bottom plate 12 to come into close contact with the heat source. In addition, since the circuit board 50 on which the circuits driven by the electric power obtained by the thermoelectric power generation module 40 are mounted is embedded in the thermoelectric power generation unit 1A, knowledge about electronic circuits is not needed during the use of the thermoelectric power generation unit 1A. Moreover, in the thermoelectric power generation unit 1A of this embodiment, since the thermoelectric power generation module 40 is stored in the housing including the bottom plate 12, the side wall 14, and the heat exchange member 20, the user does not need to additionally pay attention to the protection from impacts and the like.

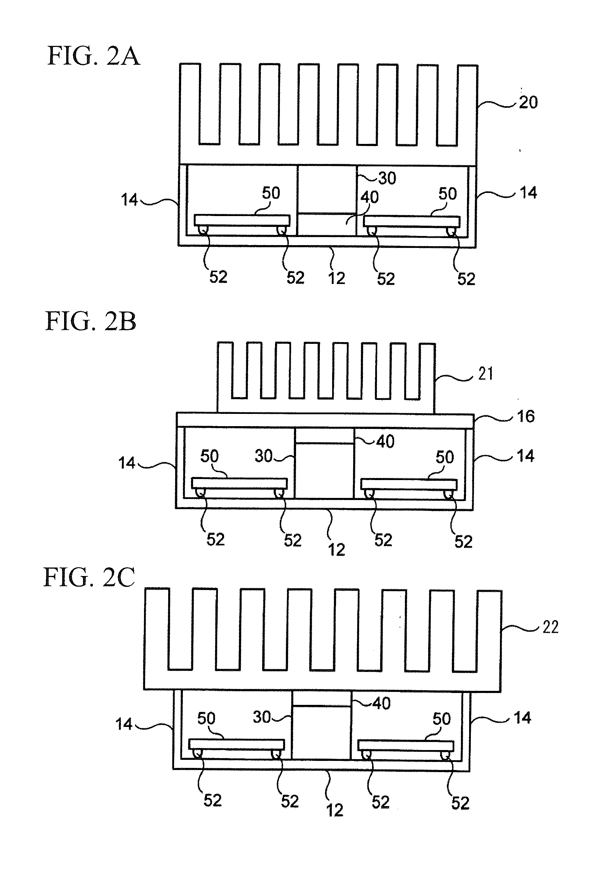

According to this embodiment as such, the temperature monitoring system which does not need the external power supply can be simply constructed only by installing the thermoelectric power generation unit 1A. In addition, in this embodiment, the spacer 30 is placed on the bottom plate 12 and the thermoelectric power generation module 40 is further placed thereon. However, as illustrated in FIG. 2A, the thermoelectric power generation module 40 may be placed on the bottom plate 12 and the spacer 30 may be placed thereon, or the thermoelectric power generation module 40 may be interposed between two spacers.

In this embodiment, the bottom surface of the heat exchange member 20 and the bottom plate 12 have the same area. However, as illustrated in FIG. 2B, a heat exchange member 21 in which the area of the bottom surface is smaller than the bottom plate 12 may be used. In this case, as illustrated in FIG. 2B, a cover 16 which has the same dimensions as the bottom plate 12 and is formed of a thermal conductor in a plate shape may be used to cover the opening of the case including the bottom plate 12 and the side wall 14, and the heat exchange member 20 may be installed on the cover 16.

In addition, as illustrated in FIG. 2C, a heat exchange member 22 in which the area of the bottom surface is larger than that of the bottom plate 12 may be also used. At least from the viewpoint of securing a sufficient cooling capacity for the thermoelectric power generation module 40 (securing a sufficient power generation capacity to drive each of the circuits mounted on the circuit board 50), the heat exchange member having a sufficient size may be selected to configure the thermoelectric power generation unit.

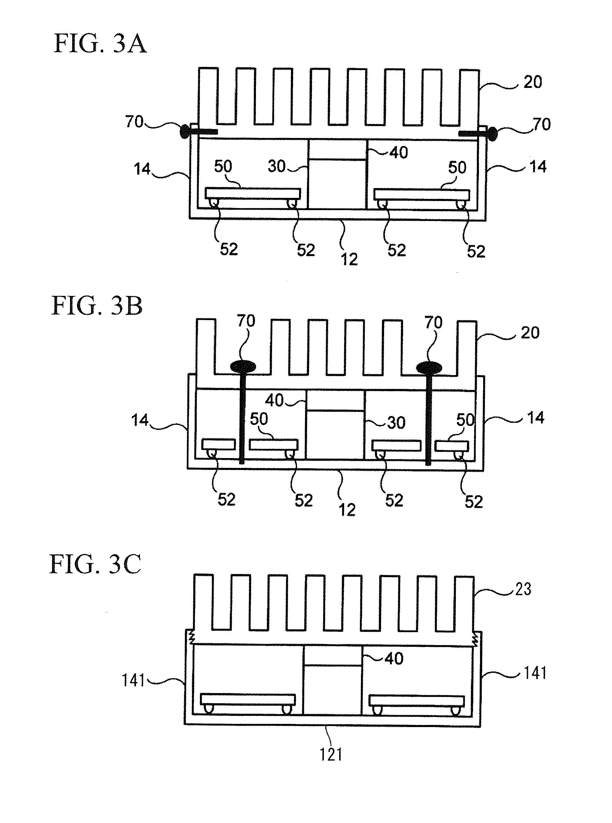

In addition, in order to cause the bottom surface of the heat exchange member 20 not to rise from the thermoelectric power generation module 40 even when the thickness of the thermoelectric power generation module 40 changes with age or the like, as illustrated in FIG. 3A or 3B, the heat exchange member 20 may screwed to the case including the bottom plate 12 and the side wall 14 using a screw 70. Positions or the number of places to be screwed may be appropriately selected in a range in which an object of causing the bottom surface of the heat exchange member 20 not to rise from the thermoelectric power generation module 40 even when the thickness of the thermoelectric power generation module 40 changes with age or the like is achieved.

Otherwise, the bottom plate 12 and the bottom surface of the heat exchange member 20 may be formed in a disc shape. In this case, as illustrated in FIG. 3C, threaded grooves which are engaged with the side surface of a heat exchange member 23 may be cut from the inner side of a side wall 141 such that the heat exchange member 23 is screwed and fixed to the opening portion of a case including a bottom plate 121 and a

side wall 141.

### (Second Embodiment)

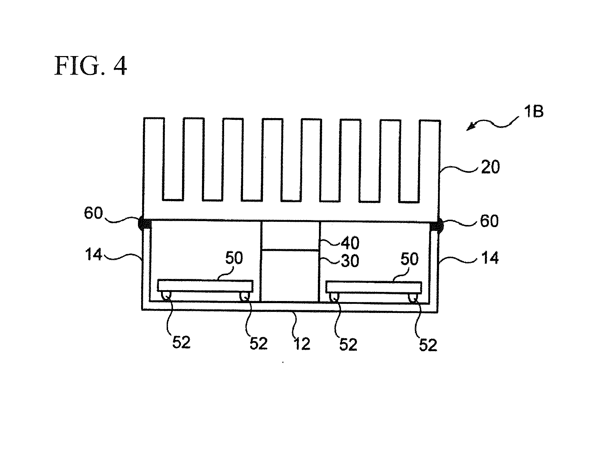

FIG. 4 is a cross-sectional view illustrating the configuration of a thermoelectric power generation unit 1B of a second embodiment of the present invention. As illustrated in FIG. 4, in the thermoelectric power generation unit 1B of this embodiment, a height which is the sum of the height of the spacer 30 and the thickness of the thermoelectric power generation module 40 is slightly greater than the height of the side wall 14, the thermoelectric power generation unit 1B is different from the thermoelectric power generation unit 1A of the first embodiment in that there is a gap between the upper end of the side wall 14 and the bottom surface of the heat exchange member 20 and the gap is covered by a sealing member 60.

In this embodiment, the sealing member 60 is formed by a method of applying a sealing material obtained by gelating a material having flexibility and having a lower thermal conductivity than a thermal conductor (for example, elastomer or rubber) such as copper or aluminum.

According to this embodiment, the user can also construct the system which monitors the temperature of an object without the need for an external power supply only by installing the thermoelectric power generation unit 1B so that the bottom plate 12 comes into close contact with the object which is the heat source for the thermoelectric power generation module 40 and requires temperature monitoring.

In addition, in the thermoelectric power generation unit 1B of this embodiment, since the bottom surface of the heat exchange member 20 and the upper end of the side wall 14 are joined together via the sealing member 60 formed of the material having a lower thermal conductivity than the thermal conductor, thermal conduction from the side wall 14 to the heat exchange member 20 is impeded, and thus the side wall 14 and the heat exchange member 20 are thermally separated from each other. Since the side wall 14 and the heat exchange member 20 are thermally separated from each other, the bottom plate 12 is also thermally separated from the heat exchange member 20 in the thermoelectric power generation unit IB. Therefore, even when the thermoelectric power generation unit 1B is installed so that the bottom plate 12 comes into close contact with the heat source, heat is avoided from being uselessly transferred from the bottom plate 12 to the heat exchange member 20 via the side wall 14, there is no problem of a reduction in heat dissipation efficiency in the heat exchange member 20 or a reduction in power generation efficiency in the thermoelectric power generation module 40 caused therefrom. In addition, since the gap between the upper end of the side wall 14 and the bottom surface of the heat exchange member 20 is blocked by the sealing member 60, failure due to the infiltration of dust, moisture, or the like can also be prevented. Furthermore, even when a change in the thickness of the thermoelectric power generation module 40 occurs with age, since the sealing member 60 is formed of the material having flexibility, a fracture of the joint portion by the sealing member 60 does not occur.

In addition, the gap between the bottom surface of the heat exchange member 20 and the upper end of the side wall 14 may be partially provided. For example, only one of the side walls 14 may directly come into contact with the bottom surface of the heat exchange member 20, and the others come into contact with the bottom surface of the heat exchange member 20 via the above-mentioned sealing material. In this case, a fracture of the joint portion can be prevented as the heat exchange member 20 is inclined.

As described above, in the thermoelectric power generation unit of the embodiment, the bottom plate 12 is thermally separated from the heat exchange member 20. In this mode, heat is avoided from being directly transferred from the bottom plate 12 to the heat exchange member 20 without via the thermoelectric power generation module 40, and thus there is an advantage a reduction in power generation efficiency does not occur. Here, as a specific mode in which the bottom plate 12 is thermally separated from the heat exchange member 20, there is a mode in which the bottom plate is joined to the heat exchange member via the sealing member 60 having heat insulation properties and the side wall. In addition, a mode in which the side wall 14 is formed using an insulating material (that is, a material having heat insulation properties) such as rubber and the bottom plate 12 is joined to the heat exchange member 20 via the side wall 14 is considered. In the former mode, it is preferable that the sealing member be formed of a material having flexibility.

When the thermoelectric power generation module 40 is used over a long period of time, there may be a case where the thickness thereof changes with age. However, when the sealing member 60 is formed of the material having flexibility, even though the change in the thickness of the thermoelectric power generation module 40 occurs and a force is exerted in a direction in which the bottom plate 12 and the heat exchange member 20 are separated from each other, a fracture of the joint portion due to the exertion of the force can be avoided.

Similarly, even in a case where the side wall 14 is formed of the material having heat insulation properties, it is preferable that the material have flexibility in addition to heat insulation properties.

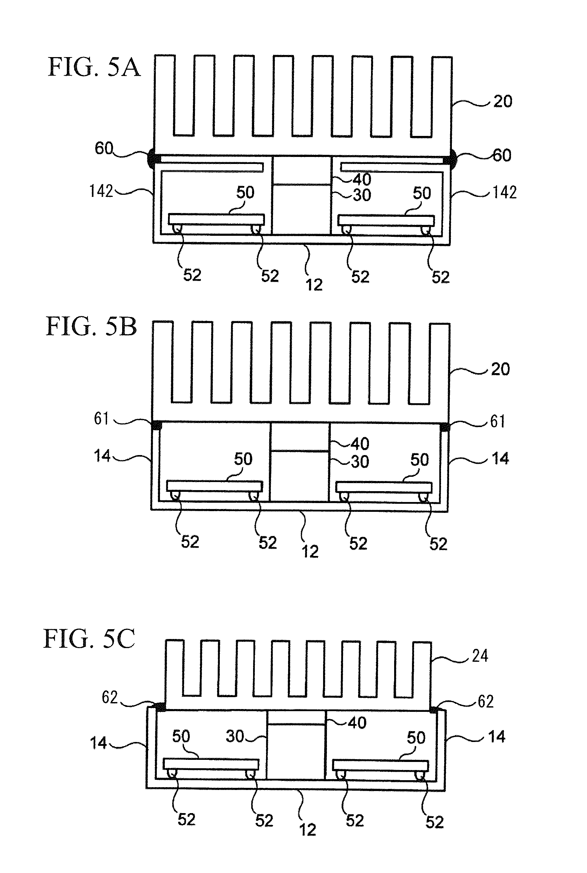

While the second embodiment of the present invention has been described above, as illustrated in FIG. 5A, the upper end of the side wall 14 may have a shape that is bent inward.

In addition, instead of forming the sealing member 60 by applying the sealing material, as illustrated in FIG. 5B, a sealing member 61 made by molding a sealing material in an annular shape may be attached to the upper end of the side wall 14 and the heat exchange member 20 may be placed thereon.

In addition, in a case of using a heat exchange member 24 in which the dimensions of the bottom surface are smaller than those of the bottom plate 12, as illustrated in FIG. 5C, a sealing member 62 may be formed by applying a sealing material to fill a gap between the inside of the side wall 14 and the side surface of the heat exchange member 24. In FIG. 5C, the side wall 14 may extend upward so that a gap where the side wall 14 and the side surface of the heat exchange member 24 face each other is provided. Accordingly, the height of the gap through which the sealing material can be injected is increased, and thus airtightness of the space can be increased.

In addition, instead of integrally molding the bottom plate 12 and the side wall 14, the bottom surface of the heat exchange member and the side wall 14 may be integrally molded and the lower end of the side wall 14 and the bottom plate 12 may be joined together by the sealing material.

Otherwise, instead of integrally molding any one of the bottom plate and the bottom surface of the heat exchange member, and the side wall, the side wall may be provided as a separate member from the bottom plate and the heat exchange member. In this case, when the side wall is formed of a thermal conductor, the side wall may be thermally separated from at least one of the bottom plate and the heat exchange member using the above-mentioned sealing member or the like.

Otherwise, the side wall may be formed of a heat insulation material such as rubber or resin (acryl, Teflon (registered trademark), or the like) or a material having a lower thermal conductivity than a thermal conductor to thermally separate the bottom plate and the heat exchange member from each other. In this case, the sealing material may be omitted, or the sealing material may be used to secure the airtightness of the space.

### (Third Embodiment)

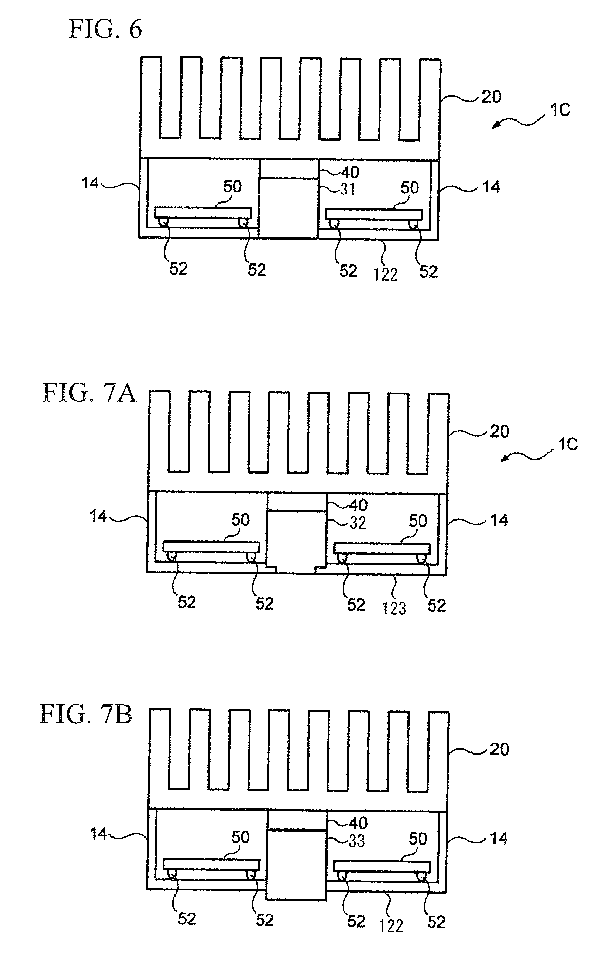

FIG. 6 is a cross-sectional view illustrating the configuration of a thermoelectric power generation unit 1C of a third embodiment of the present invention. As illustrated in FIG. 6, the thermoelectric power generation unit 1C of this embodiment is different from the thermoelectric power generation unit 1A of the first embodiment and the thermoelectric power generation unit 1B of the second embodiment in that a through-hole is provided in a bottom plate 122 so that a spacer 31 comes in direct contact with a heat source.

The spacer 31 is provided in the through-hole of the bottom plate 122 and a part thereof is exposed to the outside of the space partitioned by the bottom plate 122, the side wall 14, and the heat exchange member 20. In this embodiment described above, since the part of the spacer 31 is exposed to the outside of the space via the through-hole, the spacer 31 and the heat source directly exchange heat with each other, and thus the power generation efficiency can be increased.

In addition, since the spacer 31 and the heat source directly exchange heat with each other, the bottom plate 122 may be formed of a material other than a thermal conductor. For example, when the bottom plate 122 is made of a material (or a heat insulation material) having a low thermal conductivity, such as resin or rubber, heat can be avoided from being transferred from the heat source to the circuit board 50 disposed on the bottom plate 122. As described above, by forming the bottom plate 122 of the thermoelectric power generation unit 1C of the material (or the heat insulation material) having a low thermal conductivity, even in a case where the temperature of the heat surface is a high temperature that can affect each of the circuits on the circuit board 50, there is no problem in each of the circuit caused by the temperature.

In order to avoid a spacer 32 from falling from the thermoelectric power generation unit 1C, as illustrated in FIG. 7A, a stepped portion may be provided in the through-hole of a bottom plate 123 so that the tip end of the spacer 32 has a shape that is fitted in the stepped portion.

In addition, as illustrated in FIG. 7B, the tip end of a spacer 33 may be allowed to protrude from the bottom plate 122. In this case, the spacer 33 may be allowed to reliably come into contact with an object that is a heat source, and thus the heat generation efficiency can be increased.

In addition, in the example illustrated in FIG. 7B, by allowing the tip end of the spacer 33 to protrude from the bottom plate 122, a protrusion which is part of the spacer 33 that protrudes outward is formed. However, a protrusion which protrudes outward from the center of the bottom plate 12 of the thermoelectric power generation unit 1A having the configuration illustrated in FIG. 1B may also be provided. For example, integrally molding the bottom plate 12 and the protrusion into the thermal conductor, or attaching a thermal conductor having a smaller plate shape than that of the bottom plate 12 to the center of the bottom plate 12 molded in the plate shape to use the plate-like body as the protrusion may be considered.

As described above, in order to mount the thermoelectric power generation unit having the protrusion that protrudes outward from the center of the bottom plate 12 to the object that is the heat source, an adhesive sheet or the like having substantially the same thickness as a gap between the object and the bottom surface of the bottom plate 12 (in other words, the thickness of the protrusion) may be attached to the periphery of the protrusion, thereby realizing the mounting.

### (Modifications)

While the first, the second, and the third embodiments of the present invention have been described above, as a matter of course, the following modifications can be added to the embodiments.
(1) In each of the embodiments, the temperature sensor is employed as an example of the sensor mounted in the circuit board 50. However, different types of sensors such as a humidity sensor, a gas sensor, a carbon dioxide sensor, and vibration sensor may also be used depending on the monitoring objects. There may be a case where the above-described sensor measures the surroundings of the thermoelectric power generation unit. In this case, it is possible to take the detection portion of the sensor out of the thermoelectric power generation unit. In addition, to correspond to a sensor such as a humidity sensor, a gas sensor, or a carbon dioxide sensor, or the like which is operated by allowing the space where the circuit board 50 is disposed and an external space to communicate with each other, the space where the circuit board 50 is disposed and the external space may be allowed to communicate with each other via an opening portion provided by omitting part of the above-described sealing material or forming a through-hole in the side wall 14. In this case, in order to block dirt or dust, the opening portion may be covered with a member through which gas passes, such as non-woven fabric, Japanese paper, mesh, or textile.
(2) In the second embodiment, the case where a material having heat insulation properties and flexibility is used as the material for forming the sealing member 60 is described. However, the sealing member 60 may also be formed using a material depending on the environment in which the thermoelectric power generation unit is used, such as a material having light resistance in addition to heat insulation properties and flexibility.
(3) The heat exchange member 20 may be placed by applying high thermal conductive grease such as silicon grease to the thermoelectric power generation module 40 in each of the embodiments.

While the several embodiments of the present invention have been described above, the embodiments are presented as examples and are not intended to limit the scope of the invention. The embodiments can be embodied in other various forms, and various omissions, substitutions, and modifications can be made in a range that does not deviate from the gist of the invention. When the embodiments and the modifications are included in the scope or the gist of the invention, they are also included in a range equivalent to the invention described in the appended claims.

While preferred embodiments of the invention have been described and illustrated above, it should be understood that these are exemplary of the invention and are not to be considered as limiting. Additions, omissions, substitutions, and other modifications can be made without departing from the scope of the present invention. Accordingly, the invention is not to be considered as being limited by the foregoing description, and is only limited by the scope of the appended claims.

## Claims

1. A thermoelectric power generation unit comprising:
a heat exchange member;
a bottom plate made of a thermal conductor;
a thermoelectric power generation module interposed between the bottom plate and the heat exchange member;
a side wall provided to cover a gap between the bottom plate and the heat exchange member; and
a circuit board disposed in a space partitioned by the heat exchange member, the bottom plate, and the side wall and having a circuit mounted thereon, the circuit being driven by electric power obtained by the thermoelectric power generation module.

2. The thermoelectric power generation unit according to claim 1, wherein the bottom plate is thermally separated from the heat exchange member.

3. The thermoelectric power generation unit according to claim 2, wherein the bottom plate is joined to the heat exchange member via the side wall and a sealing member having heat insulation properties.

4. The thermoelectric power generation unit according to any one of claims 1 to 3, further comprising:
a spacer made of a thermal conductor and laminated with the thermoelectric power generation module,
wherein the spacer is provided in the space.

5. The thermoelectric power generation unit according to any one of claims 1 to 4, further comprising:
a spacer made of a thermal conductor and laminated with the thermoelectric power generation module,
wherein a part of the spacer protrudes from the bottom plate so as to be provided outside the space.

6. The thermoelectric power generation unit according to any one of claims 1 to 5, wherein:
the thermoelectric power generation module is disposed at the center of the bottom plate;
the circuit board has substantially the same external dimensions as the bottom plate; and
a cutout is provided in the circuit board, the thermoelectric power generation module being disposed in the cutout.
